(19) Europäisches Patentamt
European Patent Office
Office européen des brevets

(11) **EP 4 011 994 A1**

(12) **EUROPEAN PATENT APPLICATION**
published in accordance with Art. 153(4) EPC

(43) Date of publication:
**15.06.2022 Bulletin 2022/24**

(21) Application number: 20850384.7

(22) Date of filing: **19.03.2020**

(51) International Patent Classification (IPC):
*C09J 5/00* (2006.01)          *C09J 11/06* (2006.01)
*C09J 201/00* (2006.01)        *H01L 21/304* (2006.01)
*H01L 21/301* (2006.01)

(52) Cooperative Patent Classification (CPC):
**C09J 5/00; C09J 7/38; C09J 11/06; C09J 201/00;
H01L 21/304**

(86) International application number:
**PCT/JP2020/012197**

(87) International publication number:
**WO 2021/024541 (11.02.2021 Gazette 2021/06)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **08.08.2019 JP 2019146120**

(71) Applicant: Nitto Denko Corporation
Ibaraki-shi
Osaka 567-8680 (JP)

(72) Inventors:
• **NAGATA, Mizuho**
  **Ibaraki-shi, Osaka 567-8680 (JP)**
• **TACHIKAWA, Yu**
  **Ibaraki-shi, Osaka 567-8680 (JP)**
• **HIRANO, Keisuke**
  **Ibaraki-shi, Osaka 567-8680 (JP)**
• **MATSUSHITA, Kiichiro**
  **Ibaraki-shi, Osaka 567-8680 (JP)**

(74) Representative: **Hoffmann Eitle
Patent- und Rechtsanwälte PartmbB
Arabellastraße 30
81925 München (DE)**

(54) **METHOD FOR REMOVING ADHEREND AND ADHESIVE COMPOSITION**

(57)    A method for releasing an adherend of the present invention includes a first step and a second step. In the first step, a bonded product (100) including a pressure-sensitive adhesive layer (10), and an adherend (20) bonded thereto is prepared. The pressure-sensitive adhesive layer (10) includes a pressure-sensitive adhesive component and a heat-expandable agent. In the second step, an energy ray (R) is irradiated from the pressure-sensitive adhesive layer (10)-side of the bonded product (100) toward the adherend (20). A transmittance of the energy ray (R) in the pressure-sensitive adhesive layer (10) is 60% or more. The pressure-sensitive adhesive composition of the present invention is a composition used for forming the pressure-sensitive adhesive layer (10) in the method.

EP 4 011 994 A1

FIG. 1A

FIG. 1B

FIG. 1C

**Description**

TECHNICAL FIELD

The present invention relates to a method for releasing an adherend and a pressure-sensitive adhesive composition.

BACKGROUND ART

A pressure-sensitive adhesive sheet including a heat-peeling type pressure-sensitive adhesive layer has been conventionally known. The heat-peeling type pressure-sensitive adhesive layer contains, for example, a heat-foaming agent which can generate foaming by heating. After the pressure-sensitive adhesive sheet is bonded to an adherend on the heat-peeling type pressure-sensitive adhesive layer, the pressure-sensitive adhesive layer is heated to make the heat-foaming agent generate foaming for peeling the adhesive sheet from the adherend. Thus, a pressure-sensitive adhesive force of the pressure-sensitive adhesive layer decreases, and the adherend is separated from the pressure-sensitive adhesive layer. The heat-peeling type pressure-sensitive adhesive sheet is, for example, described in Patent Document 1 below.

Citation List

Patent Document

Patent Document 1: Japanese Unexamined Patent Publication No. 2012-167178

SUMMARY OF THE INVENTION

PROBLEM TO BE SOLVED BY THE INVENTION

In the above-described separating operation between the conventional heat-foaming type pressure-sensitive adhesive sheet and the adherend to which the adhesive sheet is bonded, the entire pressure-sensitive adhesive layer of the pressure-sensitive adhesive sheet is heated. For example, a predetermined heating means such as a heat block is brought into contact with the adherend, and the pressure-sensitive adhesive layer is heated via the adherend. Alternatively, the adherend with the heat-foaming type pressure-sensitive adhesive sheet is disposed in a heating furnace to heat the pressure-sensitive adhesive layer.

However, in such heating, a thermal load on the adherend tends to be large, which may be unpreferable. When the adherend is in particular an electronic component such as a semiconductor component, a reduction in the thermal load on the adherend is required.

In addition, when the entire pressure-sensitive adhesive layer of the conventional heat-foaming type pressure-sensitive adhesive sheet is heated during the separating operation between the adhesive sheet and the adherend to which the adhesive sheet is bonded, foaming due to the heat-foaming agent occurs throughout the entire pressure-sensitive adhesive layer. According to such foaming, fragmentated pressure-sensitive adhesive components tend to be generated from the pressure-sensitive adhesive layer, and adhesive component residues tend to be generated on the surface of the adherend after separation.

The present invention provides a method for releasing an adherend bonded to a pressure-sensitive adhesive layer containing a heat-expandable agent, and a pressure-sensitive adhesive composition used in the releasing method which are suitable for releasing the adherend from the pressure-sensitive adhesive layer while suppressing a thermal load and pressure-sensitive adhesive component residues on the adherend.

MEANS FOR SOLVING THE PROBLEM

The present invention [1] includes a method for releasing an adherend including a first step of preparing a bonded product including a pressure-sensitive adhesive layer and an adherend bonded to the pressure-sensitive adhesive layer, the pressure-sensitive adhesive layer containing a pressure-sensitive adhesive component and a heat-expandable agent; and a second step of irradiating an energy ray from the pressure-sensitive adhesive layer-side of the bonded product toward the adherend, wherein a transmittance of the energy ray in the pressure-sensitive adhesive layer is 60% or more.

In the method for releasing the adherend, the transmittance, in the pressure-sensitive adhesive layer, of the energy ray irradiated from the pressure-sensitive adhesive layer-side of the bonded product toward the adherend in the second step is 60% or more as described above. Such a configuration is suitable for, in the second step, locally heating a pressure-sensitive adhesive surface which forms an interface with the adherend in the pressure-sensitive adhesive layer, and therefore, is suitable for efficiently heating, in the pressure-sensitive adhesive layer, the pressure-sensitive adhesive surface and a heat-expandable agent in the vicinity of the adhesive surface for a short time to release or remove the adherend from the pressure-sensitive adhesive layer. Therefore, this method is suitable for suppressing a thermal load on the adherend.

In addition, the present method is suitable for locally generating gas from a heat-foaming agent in a pressure-sensitive adhesive surface by heating even when the heat-foaming agent is used as a heat-expandable agent. Such local gas generation is suitable for suppressing an amount of fragmentation of the pressure-sensitive adhesive components, and therefore, is suitable for suppressing the pressure-sensitive adhesive component residues on the surface of the adherend after being released from the pressure-sensitive adhesive layer.

The present invention [2] includes the method for releasing an adherend described in the above-described [1], wherein a transmittance of the energy ray in the adherend is lower than the transmittance of the energy ray in the pressure-sensitive adhesive layer.

Such a configuration is suitable for suppressing the transmittance, in the adherend, of the energy ray irradiated from the pressure-sensitive adhesive layer-side of the bonded product toward the adherend in the second step, and suitable for locally heating the pressure-sensitive adhesive surface which forms an interface with the adherend in the pressure-sensitive adhesive layer, which contributes to the above-described suppression of the thermal load and pressure-sensitive adhesive component residues on the adherend.

The present invention [3] includes the method for releasing an adherend described in the above-described [1] or [2], wherein the energy ray includes an energy ray having a wavelength of 400 nm or more.

Such a configuration is suitable for the above-described local heating of the pressure-sensitive adhesive surface of the pressure-sensitive adhesive layer when using a heat-expandable agent having a transmittance as high as, for example, 60% or more of an energy ray having a wavelength of 400 nm or more, which contributes to the above-described suppression of the thermal load and pressure-sensitive adhesive component residues on the adherend.

The present invention [4] includes the method for releasing an adherend described in any one of the above-described [1] to [3], wherein the energy ray is a xenon lamp light.

The xenon lamp is preferably used as a light source of an energy ray having a wavelength of 400 nm or more.

The present invention [5] includes a pressure-sensitive adhesive composition used for forming the pressure-sensitive adhesive layer in the method for releasing an adherend described in any one of the above-described [1] to [4].

The present invention [6] includes the pressure-sensitive adhesive composition described in the above-described [5], wherein the heat-expandable agent is a gas generating particle.

The use of the gas generating particles as a heat-expandable agent is suitable for realizing an excellent pressure-sensitive adhesive force to the adherend by suppressing a heat-expandable agent content ratio in the pressure-sensitive adhesive layer to ensure a pressure-sensitive adhesive component content ratio, and also for ensuring a gas generation amount required on releasing the adherend while suppressing the heat-expandable agent content ratio.

The present invention [7] includes the pressure-sensitive adhesive composition described in the above-described [6], wherein the gas generating particle includes an azo compound particle.

The azo compound particles can be preferably used as the gas generating particles having a high gas generation ratio.

BRIEF DESCRIPTION OF THE DRAWINGS

FIGS. 1A and 1B show one embodiment of a method for releasing an adherend of the present invention: FIG. 1A illustrating a first step of preparing a bonded product,
FIG. 1B illustrating a second step of irradiating an energy ray to the bonded product, and
FIG. 1C illustrating a state of releasing an adherend from a pressure-sensitive adhesive layer.
FIG. 2A shows a step of preparing a pressure-sensitive adhesive layer, an adherend, and a transparent substrate,
FIG. 2B shows a step of bonding the transparent substrate to the pressure-sensitive adhesive layer, and
FIG. 2C shows a step of bonding the pressure-sensitive adhesive layer on the transparent substrate to the adherend.
FIG. 3 shows one modified example of the bonded product.
FIG. 4 shows another modified example of the bonded product.
FIG. 5 shows a modified example of the method of irradiating an energy ray in the method for releasing an adherend.

**EP 4 011 994 A1**

DESCRIPTION OF EMBODIMENTS

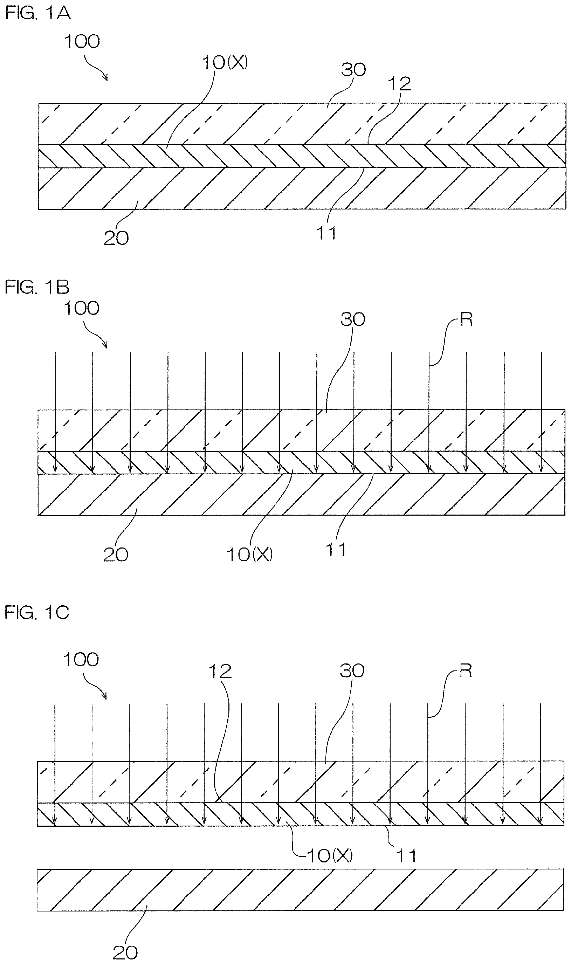

FIGS. 1A and 1B show a cross-sectional schematic view of one embodiment of a method for releasing an adherend of the present invention. The method includes the first step and the second step shown below.

In the first step, as shown in FIG. 1A, a bonded product 100 is prepared (preparation step). The bonded product 100 includes a pressure-sensitive adhesive layer 10 and an adherend 20. In this embodiment, the bonded product 100 further includes a transparent substrate 30 and has a multilayer structure including them. The pressure-sensitive adhesive layer 10 has a surface 11 and a surface 12 opposite thereto. The adherend 20 is disposed so as to be in contact with the surface 11 of the pressure-sensitive adhesive layer 10. The adherend 20 is, for example, a component or a member which is removed from the transparent substrate 30 after being joined to the transparent substrate 30 via the pressure-sensitive adhesive layer 10 and undergoing a predetermined process. The predetermined process includes, for example, processing and inspection of the adherend 20. Examples of the adherend 20 include electronic components such as semi-conductor components. Further, the transparent substrate 30 is disposed on the surface 12-side of the pressure-sensitive adhesive layer 10, and is preferably disposed so as to be in contact with the surface 12. The transparent substrate 30 functions as a support which supports the adherend 20, and examples thereof include transparent glass substrates and transparent resin substrates. A thickness of the transparent substrate 30 is, for example, 50 $\mu$m or more, preferably 100 $\mu$m or more, and is, for example, 10 mm or less, preferably 5 mm or less. A total light transmittance of the transparent substrate 30 is, for example, 90% or more, preferably 95% or more, more preferably 99% or more.

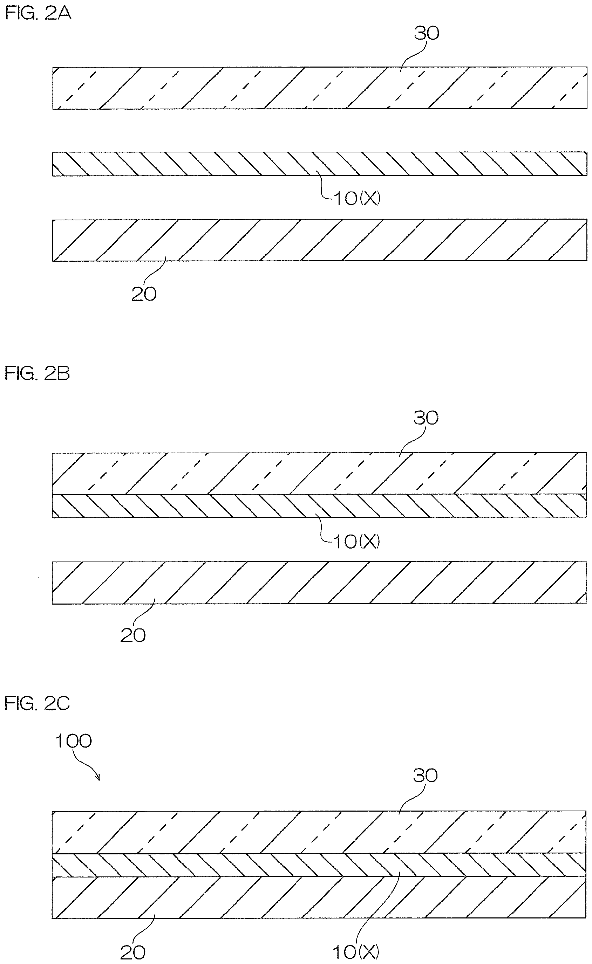

The bonded product 100 may be prepared, for example, as shown in FIG. 2. First, as shown in FIG. 2A, a pressure-sensitive adhesive sheet X, having the pressure-sensitive adhesive layer 10, the adherend 20 and the transparent substrate 30 are prepared. Next, as shown in FIG. 2B, the pressure-sensitive adhesive sheet X is bonded to the transparent substrate 30 on one side of the pressure-sensitive adhesive layer 10. Next, as shown in FIG. 2C, the adherend 20 is bonded to the other side of the pressure-sensitive adhesive layer 10 on the transparent substrate 30.

The pressure-sensitive adhesive layer 10 is a layer formed from a first pressure-sensitive adhesive composition containing a pressure-sensitive adhesive component and a heat-expandable agent.

The pressure-sensitive adhesive component develops pressure-sensitive adhesive properties of the first pressure-sensitive adhesive composition. Examples of the pressure-sensitive adhesive component include pressure-sensitive adhesive polymers (base polymers) such as acrylic polymers, rubber-based polymers, silicone-based polymers, polyester-based polymers, polyamide-based polymers, urethane-based polymers, and styrene-diene block-based polymers. The pressure-sensitive adhesive component is preferably an acrylic polymer.

The acrylic polymer is, for example, a polymer obtained by polymerization of monomer components containing an alkyl (meth)acrylate as a main monomer and containing a polar group-containing vinyl monomer as a secondary monomer. "(Meth)acrylate" refers to an acrylic acid and/or a methacrylic acid.

An example of the alkyl (meth)acrylate includes an alkyl (meth)acrylate having a straightchain or branched alkyl group having 1 to 18 carbon atoms. Examples of the alkyl (meth)acrylate include methyl (meth)acrylate, ethyl (meth)acrylate, propyl (meth)acrylate, isopropyl (meth)acrylate, n-butyl (meth)acrylate, isobutyl (meth)acrylate, sec-butyl (meth)acrylate, tert-butyl (meth)acrylate, pentyl (meth)acrylate, neopentyl (meth)acrylate, isopentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, and octadecyl (meth)acrylate. These alkyl (meth)acrylates may be used alone or in combination of two or more. When two or more kinds thereof are used in combination, preferably, a methyl methacrylate (MMA) and an alkyl acrylate having an alkyl group having 2 to 18 carbon atoms are used in combination, more preferably, MMA, an ethyl acrylate, and a 2-ethylhexyl acrylate are used in combination.

A polar group-containing vinyl monomer is a copolymerizable monomer which is copolymerizable with a main monomer. Examples of the polar group-containing vinyl monomer include hydroxyl group-containing vinyl monomers such as hydroxymethyl (meth)acrylate, hydroxyethyl (meth)acrylate, hydroxypropyl (meth)acrylate, and hydroxybutyl (meth)acrylate. Examples of the polar group-containing vinyl monomer also include carboxyl group-containing vinyl monomers such as (meth)acrylate, amide group-containing vinyl monomers such as (meth)acrylamide, amino group-containing vinyl monomers such as aminoethyl (meth)acrylate, glycidyl group-containing vinyl monomers such as glycidyl (meth)acrylate, cyano group-containing vinyl monomers such as (meth)acrylonitrile, and heterocyclic ring-containing vinyl monomers such as N-vinyl-2-pyrrolidone. As the polar group-containing vinyl monomer, preferably, a hydroxyl group-containing vinyl monomer is used, more preferably, a hydroxyethyl acrylate is used.

A ratio of the main monomer in the monomer components for forming the acrylic polymer is preferably 50% by mass or more, more preferably 60% by mass or more, and is preferably 99% by mass or less, more preferably 95% by mass or less from the viewpoint of appropriately developing basic properties such as pressure-sensitive adhesive properties of the pressure-sensitive adhesive layer 10. A ratio of the secondary monomer in the monomer components is preferably 1% by mass or more, and is preferably 20% by mass or less.

The pressure-sensitive adhesive component may contain another component in addition to the base polymer. Examples of the other component include cross-linking agents and tackifiers.

Examples of the cross-linking agent include isocyanate-based cross-linking agents, epoxybased cross-linking agents, and metal ion-based cross-linking agents, and preferably, an isocyanate-based cross-linking agent is used. A content ratio of the cross-linking agent is preferably 0.01 parts by mass or more, more preferably 0.3 parts by mass or more, and is preferably 10 parts by mass or less, more preferably 3 parts by mass or less with respect to 100 parts by mass of the base polymer of the pressure-sensitive adhesive component.

Examples of the tackifier include rosin-based resins, rosin phenol-based resins, terpenebased resins, and petroleum-based resins, and preferably, a rosin phenol-based resin is used. A content ratio of the tackifier is preferably 1 part by mass or more, more preferably 5 parts by mass or more, and is preferably 30 parts by mass or less with respect to 100 parts by mass of the base polymer of the pressure-sensitive adhesive component.

A content ratio of the adhesive component in the first pressure-sensitive adhesive composition is preferably 10% by mass or more, more preferably 20% by mass or more from the viewpoint of ensuring the pressure-sensitive adhesive properties of the first pressure-sensitive adhesive composition. Also, the content ratio thereof is preferably 99% by mass or less, more preferably 95% by mass or less.

Examples of the heat-expandable agent include gas generating agents (gas generating components) vaporized by heating, and heat-expandable microspheres.

Examples of the gas generating agent include gas generating particles which are dispersed as particles without being dissolved in the adhesive component, and a dissolving-type gas generating agent which is dissolved in the adhesive component.

Examples of the gas generating particles include particles of a heat-foaming agent which is easily gasified by heating. Examples of the heat-foaming agent include organic foaming agents and inorganic foaming agents. These heat foaming agents may be used alone or in combination of two or more.

Examples of the organic foaming agent include azo-based foaming agents, N-nitroso-based foaming agents, hydrazide-based foaming agents, semicarbazide-based foaming agents, fluorinated alkane-based foaming agents, and triazole-based foaming agents. Examples of the azo-based foaming agent include azodicarbonamide (ADCA), barium azodicarboxylate, azobisisobutyronitrile (AIBN), azocyclohexylnitrile, and azodiaminobenzene. Examples of the N-nitroso-based foaming agent include N,N'-dinitrosopentamethylenetetramine (DTP), N,N'-dimethyl-N,N'-dinitrosoterephthalamide, and trinitrosotrimethyltriamine. Examples of the hydrazide-based foaming agent include 4,4'-oxybis(benzenesulfonylhydrazide) (OBSH), paratoluenesulfonylhydrazide, diphenylsulfone-3,3'-disulfonylhydrazide, 2,4-toluenedisulfonylhydrazide, p,p-bis(benzenesulfonylhydrazide) ether, benzene-1,3-disulfonylhydrazide, and allylbis(sulfonylhydrazide). Examples of the semicarbazide-based foaming agent include p-toluylenesulfonyl semicarbazide and 4,4'-oxybis(benzenesulfonylsemicarbazide). Examples of the fluorinated alkane-based foaming agent include trichloromonofluoromethane and dichloromonofluoromethane. Examples of the triazole-based foaming agent include 5-morpholyl-1,2,3,4-thiatriazole.

Examples of the inorganic foaming agent include hydrogen carbonates such as sodium hydrogen carbonate and ammonium hydrogen carbonate, carbonates such as sodium carbonate and ammonium carbonate, nitrites such as sodium nitrite and ammonium nitrite, and borohydride salts such as sodium borohydride.

The gas generating particles are preferably particles of an organic foaming agent, more preferably particles of an azo-based foaming agent (azo compound particles), further more preferably ADCA particles. Examples of a commercially available product of the ADCA particles include the Vinyfor series and the FE series (hereinabove, manufactured by EIWA CHEMICAL IND. CO., LTD.). Unlike the hydrazide-based foaming agent such as OBSH, since the azo-based foaming agent such as ADCA has less foaming agent residues after heat foaming, it is suitable for suppressing contamination of an adherend to be described later.

Examples of a shape of the gas generating particles include a generally spherical shape, a generally plate (flat) shape, a generally needle shape, and an amorphous shape.

An average particle size of the gas generating particles is, for example, 1000 μm or less, preferably 100 μm or less, more preferably 10 μm or less, particularly preferably 7.5 μm or less, most preferably 5 μm or less from the viewpoint of uniformly generating gas in the pressure-sensitive adhesive layer 10. Further, the average particle size of the gas generating particles is preferably 0.1 μm or more from the viewpoint of reducing a content ratio of a dispersant to be described later for finely dispersing the gas generating particles.

Examples of the dissolving-type gas generating agent include azide group-containing polymers such as a glycidyl azide polymer obtained by ring-opening polymerization of 3-azidomethyl-3-methyloxetanes. In addition, for example, a dissolving-type heat-expandable agent described in Japanese Unexamined Patent Publication No. 2003-231867 may be used.

A gas generation amount of the gas generating agent is, for example, 50 ml/g or more, preferably 100 ml/g or more, more preferably 125 ml/g or more, and is, for example, 1000 ml/g or less.

When the gas generating agent is used as a heat-expandable agent, a content ratio of the gas generating agent is preferably 1 part by mass or more, more preferably 10 parts by mass or more with respect to 100 parts by mass of the base polymer of the pressure-sensitive adhesive component from the viewpoint of ensuring a gas generation amount in the pressure-sensitive adhesive layer 10. In addition, the content ratio of the gas generating agent is preferably 100 parts by mass or less, more preferably 80 parts by mass or less, further more preferably 50 parts by mass or less with respect to 100 parts by mass of the base polymer of the pressure-sensitive adhesive component from the viewpoint of ensuring an amount of the pressure-sensitive adhesive component in the pressure-sensitive adhesive layer 10.

The thermally expandable microsphere is, for example, a microsphere which has a core consisting of a gas generating component which is easily vaporized by heating, and has a shell covering it. The shell is softened by heating and increases in its internal pressure to expand by vaporization of the core in the shell. Examples of a constituent material (gas generating component) of the core include isobutane, propane, and pentane. Examples of the constituent material of the shell include polyacrylonitrile, a vinylidene chloride-acrylonitrile copolymer, and a polyvinyl alcohol. Examples of a commercially available product of a thermally expandable microsphere include the Matsumoto Microsphere F series and the Matsumoto Microsphere FE series (hereinabove, manufactured by Matsumoto Yushi-Seiyaku Co., Ltd.).

An average particle size of the thermally expandable microsphere is, for example, 100 $\mu$m or less, preferably 50 $\mu$m or less, and is, for example, 5 $\mu$m or more.

When the thermally expandable microsphere is used as a heat-expandable agent, a content ratio of the thermally expandable microsphere is preferably 5 parts by mass or more, more preferably 10 parts by mass or more with respect to 100 parts by mass of the base polymer of the pressure-sensitive adhesive component from the viewpoint of ensuring releasability on heating. In addition, a content ratio of the thermally expandable microsphere is preferably 60 parts by mass or less, more preferably 50 parts by mass or less with respect to 100 parts by mass of the base polymer of the pressure-sensitive adhesive component from the viewpoint of ensuring the amount of the pressure-sensitive adhesive component in the pressure-sensitive adhesive layer 10.

The first pressure-sensitive adhesive composition may contain another component in addition to the pressure-sensitive adhesive component and the heat-expandable agent. Examples of the other component include dispersants and pigments.

The dispersant improves dispersibility of the gas generating particles in the first pressure-sensitive adhesive composition. Examples of the dispersant include polymer-type dispersants. Examples of a commercially available product of the dispersant include the FLOWLEN DOPA series (manufactured by KYOEISHA CHEMICAL CO., LTD.), the Solsperse series (manufactured by The Lubrizol Corporation), the EFKA Series (manufactured by EFKA Additives), the Disper BYK Series (manufactured by BYK JAPAN KK), and the DISPARLON series (manufactured by Kusomoto Chemicals, Ltd.).

A content ratio of the dispersant is preferably 10 parts by mass or more, more preferably 30 parts by mass or more, and is preferably 100 parts by mass or less, more preferably 70 parts by mass or less with respect to 100 parts by mass of the gas generating particles.

The maximum gas generation amount per cm$^2$ of the pressure-sensitive adhesive layer 10 containing a heat-expandable agent is preferably 2 $\mu$l/cm$^2$ or more, more preferably 5 $\mu$l/cm$^2$ or more from the viewpoint of ensuring the releasability of an adherend in the second step to be described later. Also, the gas generation amount is, for example, 50 $\mu$l/cm$^2$ or less, preferably 40 $\mu$l/cm$^2$ or less. The maximum gas generation amount per cm$^2$ of the pressure-sensitive adhesive layer 10 refers to an amount, expressed by the volume under the conditions of 0°C and 1 atm, of gas generated in assuming that all of the gas generating agents contained in per cm$^2$ of the pressure-sensitive adhesive layer 10 are gasified. A specific calculation method for the gas generation amount is described in Examples to be described later.

The maximum gas generation amount per gram of the solid content of the first pressure-sensitive adhesive composition forming the pressure-sensitive adhesive layer 10 is preferably 5 ml/g or more, more preferably 10 ml/g or more, further more preferably 15 ml/g or more from the viewpoint of ensuring the releasability of an adherend in the second step to be described later. Also, the gas generation amount is preferably 50 ml/g or less, more preferably 40 ml/g or less. The maximum gas generation amount per gram of the solid content of the first pressure-sensitive adhesive composition refers to an amount, expressed by the volume under the conditions of 0°C and 1 atm, of gas generated in assuming that all of the gas generating agents contained in per gram of the solid content in the first pressure-sensitive adhesive composition are gasified.

A thickness of the pressure-sensitive adhesive layer 10 is preferably 1 $\mu$m or more, more preferably 5 $\mu$m or more from the viewpoint of ensuring a pressure-sensitive adhesive force to the adherend 20. The thickness of the adhesive layer 10 is preferably 200 $\mu$m or less, more preferably 100 $\mu$m or less, further more preferably 50 $\mu$m or less from the viewpoint of ensuring a transmittance of the energy ray irradiated in the second step to be described later. The thickness of the pressure-sensitive adhesive layer 10 is a distance between the surface 11 and the surface 12 of the pressure-sensitive adhesive layer 10.

The transmittance of the energy ray to be described later in the pressure-sensitive adhesive layer 10 is 60% or more, preferably 70% or more, more preferably 90% or more. When energy rays having a plurality of wavelengths are included in the energy ray to be described later, a transmittance (T) of the energy ray in the pressure-sensitive adhesive layer 10 is a value obtained by the following formula (1). In formula (1), X (λ) is a transmittance at a wavelength λ of the energy ray irradiated toward the pressure-sensitive adhesive layer 10 (the pressure-sensitive adhesive sheet X), and I (λ) is the intensity at the wavelength λ of the energy ray irradiated toward the pressure-sensitive adhesive layer 10. The transmittance of the pressure-sensitive adhesive layer 10 can be, for example, adjusted by adjusting the monomer composition and the amount of the base polymer in the pressure-sensitive adhesive layer 10, the kind and the amount of the heat-expandable agent in the pressure-sensitive adhesive layer 10, and the thickness of the pressure-sensitive adhesive layer 10.

$$\text{Transmittance}\, T = \sum X(\lambda) \cdot \frac{I(\lambda)}{\sum I(\lambda)} \qquad (1)$$

A thin film layer of several tens of nanometers that absorbs the energy ray irradiated in the second step may be formed on the surface 11 of the pressure-sensitive adhesive layer 10.

The first pressure-sensitive adhesive composition can be prepared by preparing each of the pressure-sensitive adhesive component and the heat-expandable agent, and mixing them. When the gas generating particles or the thermally expandable microsphere are used as the heat-expandable agent, the first pressure-sensitive adhesive composition can be prepared by mixing a pressure-sensitive adhesive component and a dispersion liquid obtained by dispersing the gas generating particles or the thermally expandable microsphere in an organic solvent (dispersion medium).

Examples of the organic solvent include ethyl acetate, butyl acetate, acetone, methyl ethyl ketone, methyl isobutyl ketone, benzene, toluene, xylene, methanol, ethanol, isopropanol, ethylene glycol monomethyl ether acetate, propylene glycol monomethyl ether acetate, dichloromethane, and chloroform.

A content ratio of the organic solvent in the dispersion liquid is adjusted so that a content ratio of the gas generating particles or the thermally expandable microsphere in the dispersion liquid is, for example, 1% by mass or more, preferably 5% by mass or more, and is, for example, 50% by mass or less, preferably 30% by mass or less.

The gas generating particles or the thermally expandable microsphere may be dispersed in the organic solvent in the presence of the above-described dispersant. Further, the gas generating particles may be dispersed, preferably together with a dispersant, in the organic solvent using a dispersing machine such as a mill including a bead mill.

By applying the first pressure-sensitive adhesive composition thus obtained onto a substrate sheet to form a coating film, and then, by drying the coating film to remove the organic solvent as required, the pressure-sensitive adhesive layer 10 consisting of the solid content of the pressure-sensitive adhesive composition can be formed as the pressure-sensitive adhesive sheet X. The exposed surface of the pressure-sensitive adhesive layer 10 on the substrate sheet may be covered with another substrate sheet. These substrate sheets are peeled from the pressure-sensitive adhesive sheet X in preparing the above-described bonded product 100. Examples of the substrate sheet include plastic-based substrate sheets such as polyethylene terephthalate (PET) sheets, polyethylene sheets, polypropylene sheets, polyvinyl chloride sheets, polyimide sheets, polyamide sheets, and rayon sheets.

In the second step in the method for releasing an adherend, as shown in FIG. 1B, an energy ray R having a transmittance of 60% or more with respect to the pressure-sensitive adhesive layer 10 is irradiated from the side of the transparent substrate 30 and the pressure-sensitive adhesive layer 10 of the bonded product 100 toward the adherend 20, and the surface 11 (pressure-sensitive adhesive surface) which forms an interface with the adherend 20 in the pressure-sensitive adhesive layer 10 is locally heated. In this step, an energy ray R having a single wavelength may be used, or an energy ray R having a plurality of wavelengths may be used. Preferably, a xenon lamp light is used as the energy ray R. Also, a laser having a predetermined single wavelength may be used as the energy ray.

In this step, the pressure-sensitive adhesive force of the pressure-sensitive adhesive layer 10 with respect to the adherend 20 decreases due to the function of the heat-expandable agent generated by the above-described local heating in the pressure-sensitive adhesive layer 10, and as shown in FIG. 1C, the adherend 20 is released from the pressure-sensitive adhesive layer 10. On the other hand, the surface 12 opposite to the surface 11 of the pressure-sensitive adhesive layer 10 is not affected by heating due to the energy ray irradiation, and maintains a bonding state with respect to the transparent substrate 30.

In the second step of this method, the energy ray R having a transmittance of 60% or more with respect to the pressure-sensitive adhesive layer 10 is irradiated from the side of the transparent substrate 30 and the pressure-sensitive adhesive layer 10 toward the adherend 20 in the bonded product 100. This is suitable for locally heating the surface 11 (pressure-sensitive adhesive surface) which forms an interface with the adherend 20 in the pressure-sensitive adhesive layer 10, and therefore, is suitable for efficiently heating, in the pressure-sensitive adhesive layer 10, the pressure-sensitive adhesive surface and the heat-expandable agent in the vicinity of the adhesive surface 11 for a short time. Therefore, this method is suitable for suppressing a thermal load on the adherend 20.

In addition, the present method is suitable for locally generating gas from a gas generating agent in the pressure-sensitive adhesive surface by heating even when the gas generating agent is used as a heat-expandable agent in the pressure-sensitive adhesive layer 10. Such local gas generation is suitable for suppressing an amount of fragmentation of the pressure-sensitive adhesive component, and therefore, is suitable for suppressing the pressure-sensitive adhesive component residues on the surface of the adherend 20 after being released from the pressure-sensitive adhesive layer 10.

As described above, the present method is suitable for releasing the adherend 20, bonded to the pressure-sensitive adhesive layer 10 containing the heat-expandable agent, from the pressure-sensitive adhesive layer 10 while suppressing the thermal load and pressure-sensitive adhesive component residues on the adherend.

In this method, the transmittance of the energy ray in the adherend 20 is preferably lower than that of the energy ray in the pressure-sensitive adhesive layer 10. Such a configuration is suitable for suppressing the transmittance, in the adherend 20, of the energy ray irradiated from the pressure-sensitive adhesive layer 10-side of the bonded product 100 toward the adherend 20 and suitable for locally heating the surface 11 (pressure-sensitive adhesive surface) of the pressure-sensitive adhesive layer 10, which contributes to the above-described suppression of the thermal load and pressure-sensitive adhesive component residues on the adherend 20.

The energy ray preferably includes an energy ray having a wavelength of 400 nm or more. Such a configuration is suitable for the above-described local heating of the surface 11 (pressure-sensitive adhesive surface) of the pressure-sensitive adhesive layer 10 when using a heat-expandable agent having a transmittance as high as, for example, 60% or more of an energy ray having a wavelength of 400 nm or more, which contributes to the above-described suppression of the thermal load and pressure-sensitive adhesive component residues on the adherend 20. Examples of the heat-expandable agent having a transmittance of 60% or more of the energy ray having a wavelength of 400 nm or more include ADCA particles. The configuration in which the pressure-sensitive adhesive layer 10 contains the heat-expandable agent having a transmittance of the energy ray having a wavelength of 400 nm or more of 60% or more is suitable for suppressing a gas generation by heating due to energy ray irradiation of a heat-expandable agent which is present other than the pressure-sensitive adhesive surface (the surface 11) which forms an interface with the adherend in the pressure-sensitive adhesive layer 10, and is suitable for locally generating gas from the heat-expandable agent in the pressure-sensitive adhesive surface by heating.

The energy ray is preferably a xenon lamp light as described above. The xenon lamp is preferable as a light source of the energy ray having a wavelength of 400 nm or more.

As described above, the heat-expandable agent in the pressure-sensitive adhesive layer 10 is preferably gas generating particles, and more preferably azo compound particles. The configuration in which the pressure-sensitive adhesive layer 10 contains the gas generating particles as a heat-expandable agent having a large gas generation amount is suitable for realizing an excellent pressure-sensitive adhesive force to the adherend by suppressing a heat-expandable agent content ratio in the pressure-sensitive adhesive layer 10 to ensure a pressure-sensitive adhesive component content ratio, and also for ensuring a gas generation amount on releasing the adherend while suppressing the heat-expandable agent content ratio.

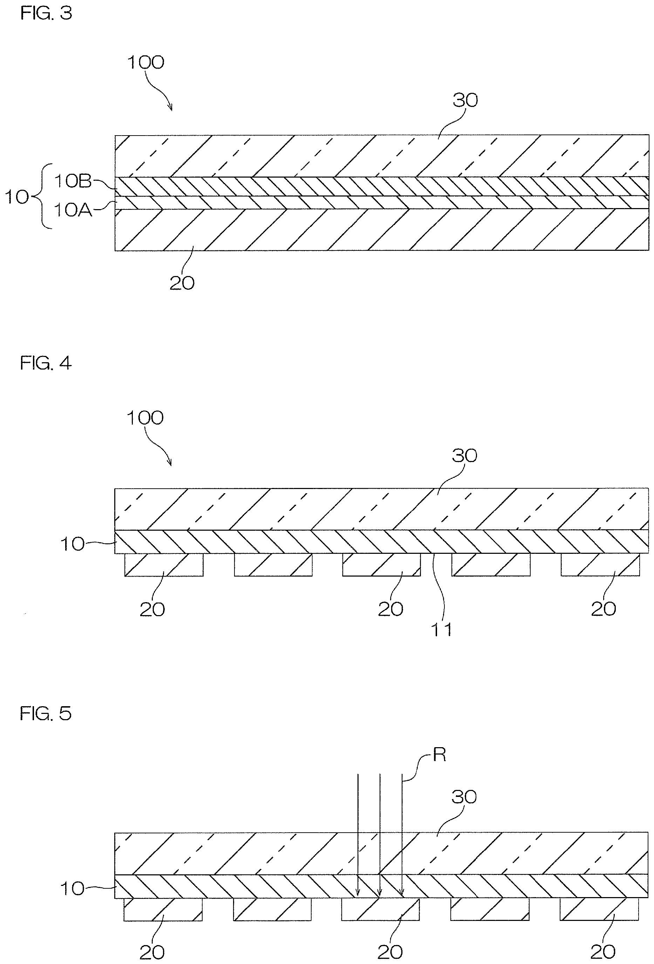

As shown in FIG. 3, the pressure-sensitive adhesive layer 10 of the bonded product 100 may have a two-layer configuration of a first layer 10A located on the adherend 20-side and a second layer 10B located on the transparent substrate 30-side, instead of the single layer configuration described above. The first layer 10A is a layer formed from the above-described first pressure-sensitive adhesive composition, and the component composition thereof is the same as that described above regarding the pressure-sensitive adhesive layer 10. The second layer 10B is a layer which does not contain a heat-expandable agent, and is, for example, a layer formed from a second pressure-sensitive adhesive composition having the same component composition as the first pressure-sensitive adhesive composition except that it contains no heat-expandable agent. According to such a modified example, in the pressure-sensitive adhesive layer 10, the transmittance of the energy ray with respect to the pressure-sensitive adhesive layer 10 is easily increased, while the pressure-sensitive adhesive force of the pressure-sensitive adhesive layer 10 with respect to the adherend 20 is ensured. In this modified example, the maximum gas generation amount per cm² of the pressure-sensitive adhesive layer 10 refers to an amount, expressed by the volume under the conditions of 0°C and 1 atm, of gas generated in assuming that all of the gas generating agents contained in per cm² of the pressure-sensitive adhesive layer 10 including the first layer 10A and the second layer 10B are gasified.

As shown in FIG. 4, for example, the bonded product 100 may have the plurality of adherends 20 instead of one adherend 20 on the surface 11 of the pressure-sensitive adhesive layer 10 (the same applies when the pressure-sensitive adhesive layer 10 has a two-layer configuration shown in FIG. 3). In this case, in the second step (energy ray irradiation step), as shown in FIG. 5, for example, the energy ray may be irradiated for each region to which one adherend 20 is bonded in the pressure-sensitive adhesive layer 10. Thus, it is possible to selectively release the plurality of adherends 20 from the pressure-sensitive adhesive layer 10 of the bonded product 100. Examples

[Example 1]

<Preparation of Base Polymer>

In a reaction vessel equipped with a stirrer, a thermometer, a reflux condenser, and a nitrogen gas introduction pipe, a mixture containing 70 parts by mass of an ethyl acrylate, 30 parts by mass of a 2-ethylhexyl acrylate, 4 parts by mass of a hydroxyethyl acrylate, 5 parts by mass of a methyl methacrylate, 0.2 parts by mass of a 2,2'-azobisisobutyronitrile (AIBN) as a polymerization initiator, and an ethyl acetate as a solvent was stirred at 60°C for 7 hours under a nitrogen atmosphere (polymerization reaction). Thus, a polymer solution containing an acrylic polymer was obtained.

<Preparation of Gas Generating Particle Dispersion Liquid>

A mixture containing 20 g of gas generating particles (trade name "FE-788", ADCA particles, average particle size of 6 $\mu$m, gas generation amount of 135 mL/g, manufactured by EIWA CHEMICAL IND. CO., LTD.), 10 g of a dispersant (trade name "FLOWLEN DOPA-100", manufactured by KYOEISHA CHEMICAL CO., LTD.), and 70 g of an ethyl acetate was stirred with a bead mill for one hour to pulverize the gas generating particles. Thus, a gas generating particle dispersion liquid containing the ADCA particles having an average particle size of 0.5 $\mu$m as gas generating particles was obtained.

<Fabrication of Pressure-Sensitive Adhesive Sheet>

A coating liquid (varnish) was prepared by uniformly mixing 100 parts by mass of an acrylic polymer (100 parts by mass of the solid content of the above-described polymer solution), 1.4 parts by mass of an isocyanate-based cross-linking agent (trade name "CORONATE L", manufactured by Nippon Polyurethane Industry Co., Ltd.), 50 parts by mass of a gas generating particle dispersion liquid (containing 10 parts by mass of gas generating particles), 10 parts by mass of a tackifier (trade name "SUMILITERESIN PR-12603", rosin phenol-based resin, manufactured by Sumitomo Bakelite Co., Ltd.), and an ethyl acetate. Next, the coating liquid was applied onto a first substrate sheet (separator made of PET having a thickness of 38 $\mu$m) to form a coating film, and then, the coating film was dried on the substrate sheet to form a first layer (thickness of 2 $\mu$m) of a pressure-sensitive adhesive layer. On the other hand, a second layer of the pressure-sensitive adhesive layer was formed on a second substrate sheet (separator made of PET having a thickness of 38 $\mu$m) in the same manner as in the formation of the first layer of the pressure-sensitive adhesive layer, except that the gas generating particle dispersion liquid was not used and the thickness of the second layer was changed to 20 $\mu$m instead of 2 $\mu$m. Then, the exposed surface of the first layer on the first substrate sheet was bonded to the exposed surface of the second layer on the second substrate sheet to fabricate a pressure-sensitive adhesive sheet sandwiched between the first substrate sheet and the second substrate sheet. The compositions regarding the first layer of the pressure-sensitive adhesive layer in Example 1, and other Examples and Comparative Examples to be described later are shown in Table 1 (the unit of each numerical value representing the composition is "parts by mass" in Table 1).

<Fabrication of Bonded Product>

First, the pressure-sensitive adhesive sheet was cut out into a size of 3 cm square to obtain a pressure-sensitive adhesive sheet piece. Next, after peeling the second substrate sheet on the second layer-side from the pressure-sensitive adhesive sheet piece, the pressure-sensitive adhesive sheet was bonded to a glass substrate (trade name "Large Slide Glass S9111", thickness of 1 mm, manufactured by Matsunami Glass Ind., Ltd.) on the second layer-side, and the glass and the pressure-sensitive adhesive sheet piece were compressively bonded by a compression bonding operation of one reciprocation of a 2-kg hand roller. Next, after peeling the first substrate sheet on the first layer-side of the pressure-sensitive adhesive sheet piece, a silicon wafer (thickness of 50 $\mu$m) as an adherend was bonded to the thus exposed first layer of the pressure-sensitive adhesive layer. In this manner, the bonded product of Example 1 was fabricated. The bonded product of Example 1 had a configuration in which the transparent glass substrate was joined to the silicone wafer by the pressure-sensitive adhesive layer, and the pressure-sensitive adhesive layer had a lamination configuration of the first layer (2 $\mu$m) on the silicone wafer-side and the second layer (20 $\mu$m) on the glass substrate-side.

[Example 2]

A bonded product of Example 2 was fabricated in the same manner as in the bonded product of Example 1, except that in forming the first layer of the pressure-sensitive adhesive sheet (pressure-sensitive adhesive layer), a blending amount of the gas generating particles was changed to 25 parts by mass instead of 10 parts by mass, and the thickness of the first layer was changed to 5 $\mu$m instead of 2 $\mu$m.

[Example 3]

A bonded product of Example 3 was fabricated in the same manner as in the bonded product of Example 2, except that a cycloolefin polymer (COP) film (trade name "ZEONOR ZF14-040", thickness of 40 μm, manufactured by ZEON CORPORATION) was, as an adherend, bonded to the first layer-side of the pressure-sensitive adhesive layer instead of the silicon wafer.

[Example 4]

A bonded product of Example 4 was fabricated in the same manner as in the bonded product of Example 2, except that a polyimide film (trade name "Kapton 500H", thickness of 125 μm, manufactured by DU PONT-TORAY CO., LTD.) was, as an adherend, bonded to the first layer-side of the pressure-sensitive adhesive layer instead of the silicon wafer.

[Example 5]

A bonded product of Example 5 was fabricated in the same manner as in the bonded product of Example 1, except that in forming the first layer of the pressure-sensitive adhesive sheet, a blending amount of the gas generating particles was changed to 50 parts by mass instead of 10 parts by mass.

[Example 6]

A bonded product of Example 6 was fabricated in the same manner as in the bonded product of Example 1, except that in forming the first layer of the pressure-sensitive adhesive sheet, a blending amount of the gas generating particles was changed to 50 parts by mass instead of 10 parts by mass, and 6 parts by mass of a black pigment (trade name "ATDN101 BLACK", manufactured by Dainichiseika Color & Chemicals Mfg. Co., Ltd.) was blended into the coating liquid.

[Example 7]

A bonded product of Example 7 was fabricated in the same manner as in the bonded product of Example 1, except that in forming the first layer of the pressure-sensitive adhesive sheet, 30 parts by mass of heat-expandable microspheres (trade name "Matsumoto Microsphere F-80SD", manufactured by Matsumoto Yushi-Seiyaku Co., Ltd.) was blended instead of 10 parts by mass of the gas generating particles, and the thickness of the first layer was changed to 20 μm instead of 2 μm.

[Comparative Example 1]

A bonded product of Comparative Example 1 was fabricated in the same manner as in the bonded product of Example 1, except that in forming the first layer of the pressure-sensitive adhesive sheet, a blending amount of the gas generating particles was changed to 50 parts by mass instead of 10 parts by mass, 6 parts by mass of a black pigment (trade name "ATDN101 BLACK") was blended into the coating liquid, and the thickness of the first layer was changed to 5 μm instead of 2 μm.

[Comparative Example 2]

A bonded product of Comparative Example 2 was fabricated in the same manner as in the bonded product of Example 1, except that in forming the first layer of the pressure-sensitive adhesive sheet, a blending amount of the gas generating particles was changed to 50 parts by mass instead of 10 parts by mass, 12 parts by mass of a black pigment (trade name "ATDN101 BLACK") was blended into the coating liquid, and the thickness of the first layer was changed to 5 μm instead of 2 μm.

[Comparative Example 3]

A bonded product of Comparative Example 3 was fabricated in the same manner as in the bonded product of Example 1, except that in forming the first layer of the pressure-sensitive adhesive sheet, the gas generating particle dispersion liquid was not used, and the thickness of the first layer was changed to 10 μm instead of 2 μm.

<Maximum Gas Generation Amount>

A maximum gas generation amount was examined for each of the pressure-sensitive adhesive sheets of Examples and Comparative Examples. Specifically, 2 to 3-mg pressure-sensitive adhesive sheet piece (pressure-sensitive adhesive layers) cut out from the pressure-sensitive adhesive sheet was bonded to aluminum foil and then heated using a heating furnacetype pyrolyzer (DSP). In this heating, a temperature rising rate was set at 2°C/min, and a final temperature was set at 250°C. Then, an amount of gas generated in the DSP was measured by a gas chromatography mass spectrometry. In this method, a gas chromatography apparatus (trade name "6890Plus", manufactured by Agilent Technologies) was used for gas chromatography, a mass spectrometer (trade name "5973N", manufactured by Agilent Technologies) was used for mass spectrometry, and a gas generation amount was calculated as a decane-conversion value. Then, the maximum gas generation amount per gram of the solid content of the pressure-sensitive adhesive composition forming the pressure-sensitive adhesive layer (volume under the conditions of 0°C and 1 atm) was obtained from the gas generation amount per unit mass (1 g) of the pressure-sensitive adhesive sheet (pressure-sensitive adhesive layer), and then, the maximum gas generation amount (volume under the conditions of 0°C and 1 atm) per unit area (1 $cm^2$) of the pressure-sensitive adhesive sheet was obtained. The maximum gas generation amount ($\mu l/cm^2$) per unit area (1 $cm^2$) of each pressure-sensitive adhesive sheet is shown in Table 1.

<Pressure-Sensitive Adhesive Force>

A pressure-sensitive adhesive force was examined for each of the pressure-sensitive adhesive sheets (pressure-sensitive adhesive layers) of Examples and Comparative Examples as follows. First, the second substrate sheet was peeled from the pressure-sensitive adhesive sheet sandwiched between the first substrate sheet and the second substrate sheet, and a PET sheet (thickness of 25 $\mu$m) was bonded to the thus exposed second layer-side of the pressure-sensitive adhesive layer to obtain a laminate. Next, the pressure-sensitive adhesive sheet test piece (width of 20 mm× length of 100 mm) was cut out from the laminate. Next, the first substrate sheet was peeled from the pressure-sensitive adhesive sheet test piece, the first layer-side thus exposed was bonded to a SUS plate (SUS304) as an adherend under the environment of 23°C, and the test piece was compressively bonded to the adherend by a compression bonding operation of one reciprocation of a 2-kg roller. Then, the resulting product was left to stand for 30 minutes under the environment of 23°C, and then, the pressure-sensitive adhesive force (N/20mm) was measured by carrying out a peeling test of the pressure-sensitive adhesive sheet test piece with respect to the SUS plate using a tensile testing machine (trade name "Autograph AGS-J", manufactured by Shimadzu Corporation). In this measurement, a measurement temperature was set at 23°C, a peeling angle of the test piece with respect to the SUS plate was set at 180°, and a tensile rate of the pressure-sensitive adhesive sheet test piece was set at 300 mm/min. The results are shown in Table 1.

<Transmittance>

A transmittance of the xenon lamp light was examined for each of the pressure-sensitive adhesive sheets (pressure-sensitive adhesive layers) of Examples and Comparative Examples. The transmittance of the pressure-sensitive adhesive sheet (pressure-sensitive adhesive layer) was examined in a state of a laminate after the pressure-sensitive adhesive sheet was compressively bonded to glass and the first substrate sheet was peeled, and before a silicone wafer (Examples 1, 2, 5 to 7 and Comparative Examples 1 to 3), a COP film (Example 3), or a polyimide film (Example 4) as another adherend was bonded. Specifically, first, a light transmittance over a wavelength range of 220 nm to 1200 nm of the pressure-sensitive adhesive sheet on the glass was measured using a spectrophotometer (trade name "Spectrophotometer U-4100", manufactured by Hitachi High-Tech Science Corporation). A light transmittance $T_1$ of the xenon lamp light in the pressure-sensitive adhesive sheet (pressure-sensitive adhesive layer) itself was calculated based on the following formula (2) from the obtained measurement data of the transmittance, and the intensity distribution data of the xenon lamp light (light emitted from a xenon flash lamp PulseForge 1300 manufactured by NovaCentrix and having an intensity distribution in a wavelength range of 225 nm to 1040 nm). In formula (2), X ($\lambda$) is the transmittance of the energy ray at the wavelength $\lambda$ in the pressure-sensitive adhesive sheet, and I ($\lambda$) is the intensity at the wavelength $\lambda$ of the energy ray (energy ray used in the second step in the method for releasing the adherend). Also, a light transmittance $T_2$ of the xenon lamp light of the silicone wafer (Examples 1, 2, 5 to 7 and Comparative Examples 1 to 3), the COP film (Example 3), or the polyimide film (Example 4) used for each bonded product was calculated in the same manner as in the transmittance $T_1$. The transmittances $T_1$ and $T_2$ (%) are shown in Table 1.

$$\text{Transmittance}\,T = \sum_{\lambda=225}^{1040} X(\lambda) \cdot \frac{I(\lambda)}{\displaystyle\sum_{\lambda=225}^{1040} I(\lambda)} \qquad (2)$$

<Releasability and Degree of Contamination>

The releasability and degree of contamination of the adherend after releasing were examined for each of the bonded products of Examples and Comparative Examples. Specifically, the xenon lamp light was irradiated to the bonded product, from the glass substrate-side toward the other adherend, using a xenon flash lamp (trade name "PulseForge 1300", manufactured by NovaCentrix). In the irradiation, a distance between the light source and the bonded product was set at 10 mm, the driving voltage of the light source was set at 690 V, and the irradiation pulse time was set at 500 $\mu$sec. Regarding the releasability or reworkability of the adherend, a case where the releasing of the adherend from the pressure-sensitive adhesive layer occurred by this irradiation was evaluated as "Excellent", and a case where the releasing did not occur was evaluated as "Bad". Further, a released surface of the released adherend was observed using an optical microscope (trade name "VHX-1000", manufactured by KEYENCE CORPORATION). Regarding the degree of contamination on the adherend, a case where the pressure-sensitive adhesive component residue was not confirmed was evaluated as "Excellent", and a case where the pressure-sensitive adhesive component residue was confirmed was evaluated as "Bad". The evaluation results are shown in Table 1.

[Table 1]

Table 1

| | Pressure-Sensitive Adhesive Component | | | Gas Generating Particles | Heat Expandable Microsphere | Pigment | Thickness of First Layer (μm) | Maximium Gas Generation Amount (μl/cm²) | Pressure-Sensitive Adhesive Force (N/20mm) | Transmittance $T_1$(%) | Adhesive Product | | Reworkability | Contamination Properties |
| | Acrylic Polymer | Isocyanate-Based Cross-Linking Agent | Tackifier | | | | | | | | Kind | Transmittance $T_2$ (%) | | |
|---|---|---|---|---|---|---|---|---|---|---|---|---|---|---|
| Ex.1 | 100 | 1.4 | 10 | 10 | - | - | 2 | 2.1 | 5.9 | 98.8 | Si Wafer | 1 | Excellent | Excellent |
| Ex. 2 | 100 | 1.4 | 10 | 25 | - | - | 5 | 11.3 | 2.2 | 93.6 | Si Wafer | 1 | Excellent | Excellent |
| Ex. 3 | 100 | 1.4 | 10 | 25 | - | - | 5 | 11.3 | 2.2 | 93.6 | COP Film | 90.2 | Excellent | Excellent |
| Ex. 4 | 100 | 1.4 | 10 | 25 | - | - | 5 | 11.3 | 2.2 | 93.6 | Polyimide Film | 46.3 | Excellent | Excellent |
| Ex. 5 | 100 | 1.4 | 10 | 50 | - | - | 2 | 7.2 | 4.0 | 95.9 | Si Wafer | 1 | Excellent | Excellent |
| Ex. 6 | 100 | 1.4 | 10 | 50 | - | 6 | 2 | 7.0 | 3.2 | 77.6 | Si Wafer | 1 | Excellent | Excellent |
| Ex. 7 | 100 | 1.4 | 10 | - | 30 | - | 20 | 15.7 | 3.7 | 70.8 | Si Wafer | 1 | Excellent | Excellent |
| Comparative Ex. 1 | 100 | 1.4 | 10 | 50 | - | 6 | 5 | 17.5 | 0.3 | 57.1 | Si Wafer | 1 | Excellent | Bad |
| Comparative Ex. 2 | 100 | 1.4 | 10 | 50 | - | 12 | 5 | 17.0 | 0.2 | 47.2 | Si Wafer | 1 | Excellent | Bad |
| Comparative Ex. 3 | 100 | 1.4 | 10 | - | - | - | 10 | - | 6.3 | 100 | Si Wafer | 1 | Bad | - |

INDUSTRIAL APPLICATION

The method for releasing an adherend of the present invention can be, for example, used for peeling a pressure-sensitive adhesive sheet bonded to an electronic component in a production process of the electronic component such as a semiconductor component. The pressure-sensitive adhesive composition of the present invention can be used for producing a pressure-sensitive adhesive sheet used in the method.

Description of Reference Numerals

| | |
|---|---|
| 100 | Bonded product |
| X | Pressure-sensitive adhesive sheet |
| 10 | Pressure-sensitive adhesive layer |
| 11, 12 | Surface |
| 10A | First layer |
| 10B | Second Layer |
| 20 | Adherend |
| 30 | Transparent Substrate |
| R | Energy Ray |

**Claims**

1.  A method for releasing an adherend, the method comprising:

    a first step of preparing a bonded product including a pressure-sensitive adhesive layer and an adherend bonded to the pressure-sensitive adhesive layer, the pressure-sensitive adhesive layer containing a pressure-sensitive adhesive component and a heat-expandable agent; and
    a second step of irradiating an energy ray from the pressure-sensitive adhesive layer-side of the bonded product toward the adherend,
    wherein a transmittance of the energy ray in the pressure-sensitive adhesive layer is 60% or more.

2.  The method for releasing an adherend according to claim 1,
    wherein a transmittance of the energy ray in the adherend is lower than the transmittance of the energy ray in the pressure-sensitive adhesive layer.

3.  The method for releasing an adherend according to claim 1,
    wherein the energy ray includes an energy ray having a wavelength of 400 nm or more.

4.  The method for releasing an adherend according to claim 1,
    wherein the energy ray is a xenon lamp light.

5.  A pressure-sensitive adhesive composition used for forming the pressure-sensitive adhesive layer in the method for releasing an adherend according to claim 1.

6.  The pressure-sensitive adhesive composition according to claim 5,
    wherein the heat-expandable agent is a gas generating particle.

7.  The pressure-sensitive adhesive composition according to claim 6,
    wherein the gas generating particle includes an azo compound particle.

FIG. 1A

FIG. 1B

FIG. 1C

FIG. 2A

30

10(X)

20

FIG. 2B

30

10(X)

20

FIG. 2C

100

30

20          10(X)

FIG. 3

FIG. 4

FIG. 5

<div align="center">

**INTERNATIONAL SEARCH REPORT**

</div>

| | International application No. |
|---|---|
| | PCT/JP2020/012197 |

**A. CLASSIFICATION OF SUBJECT MATTER**
Int. Cl. C09J5/00(2006.01)i, C09J11/06(2006.01)i, C09J201/00(2006.01)i,
H01L21/304(2006.01)i, H01L21/301(2006.01)i
FI: C09J5/00, C09J11/06, C09J201/00, H01L21/78 P, H01L21/304 622E
According to International Patent Classification (IPC) or to both national classification and IPC

**B. FIELDS SEARCHED**

Minimum documentation searched (classification system followed by classification symbols)
Int. Cl. C09J5/00, C09J11/06, C09J201/00, H01L21/304, H01L21/301

Documentation searched other than minimum documentation to the extent that such documents are included in the fields searched
Published examined utility model applications of Japan     1922-1996
Published unexamined utility model applications of Japan   1971-2020
Registered utility model specifications of Japan           1996-2020
Published registered utility model applications of Japan   1994-2020

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2015-124300 A (SEKISUI CHEMICAL CO., LTD.) 06 | 5-7 |
| Y | July 2015, claims, paragraphs [0001], [0029]-[0032], [0056], tables examples 4-6 | 1-4 |
| X | JP 2004-186280 A (SEKISUI CHEMICAL CO., LTD.) 02 | 5-7 |
| Y | July 2004, claims, paragraphs [0027]-[0029], [0055], example 1 | 1-4 |
| Y | JP 2005-97507 A (SEKISUI CHEMICAL CO., LTD.) 14 April 2005, claims, paragraph [0037], tables examples 1-4, comparative example 1 | 1-4 |
| Y | JP 2004-133140 A (NGK SPARK PLUG CO., LTD.) 30 April 2004, paragraph [0029], fig. 8 | 3 |

☒ Further documents are listed in the continuation of Box C.   ☒ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 27.05.2020 | 09.06.2020 |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

# EP 4 011 994 A1

| INTERNATIONAL SEARCH REPORT | International application No. |
| | PCT/JP2020/012197 |

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2017-191283 A (JAPAN DISPLAY INC.) 19 October 2017, paragraph [0046], fig. 10 | 4 |

Form PCT/ISA/210 (continuation of second sheet) (January 2015)

**INTERNATIONAL SEARCH REPORT**
Information on patent family members

| International application No. |
| --- |
| PCT/JP2020/012197 |

| Patent Documents referred to in the Report | Publication Date | Patent Family | Publication Date |
| --- | --- | --- | --- |
| JP 2015-124300 A | 06.07.2015 | (Family: none) | |
| JP 2004-186280 A | 02.07.2004 | (Family: none) | |
| JP 2005-97507 A | 14.04.2005 | (Family: none) | |
| JP 2004-133140 A | 30.04.2004 | (Family: none) | |
| JP 2017-191283 A | 19.10.2017 | CN 206758438 U | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012167178 A

- JP 2003231867 A